# EUROPÄISCHE PATENTSCHRIFT

(11) **EP 2 036 099 B1**
(45) Veröffentlichungstag und Bekanntmachung des Hinweises auf die Patenterteilung: **14.10.2009**
(21) Anmeldenummer: 07728631.8
(22) Anmeldetag: 27.04.2007
(51) Int. Cl.: H01C 7/00, G01R 19/00

(54) **BATTERIESENSOREINHEIT UND VERFAHREN ZUR HERSTELLUNG DER BATTERIESENSOREINHEIT**
BATTERY SENSOR UNIT AND METHOD FOR PRODUCING THE BATTERY SENSOR UNIT
UNITÉ DE DÉTECTEUR DE BATTERIE ET PROCÉDÉ POUR LA FABRICATION DE L'UNITÉ DE DÉTECTEUR DE BATTERIE

(30) Priorität: 26.06.2006 DE 102006029547
(43) Veröffentlichungstag der Anmeldung: 18.03.2009
(73) Patentinhaber: Robert Bosch GmbH, 70442 Stuttgart (DE)
(72) Erfinder: KERBEL, Sergej, 74336 Brackenheim (DE)
(86) Internationale Anmeldenummer: PCT/EP2007/054176
(87) Internationale Veröffentlichungsnummer: WO 2008/000537

(56) Entgegenhaltungen:
- EP-A1- 1 435 524
- DE-A1- 10 031 243
- DE-B3- 10 332 410

## Beschreibung

Die Erfindung betrifft ein Verfahren zur Herstellung einer Batteriesensoreinheit sowie eine Batteriesensoreinheit mit einer Befestigungsvorrichtung und einer Messvorrichtung nach der Gattung der unabhängigen Ansprüche.

### Stand der Technik

Zur Batteriezustandserkennung von Batterien in Kraftfahrzeugen werden in der Regel die Größen Temperatur, Strom und/oder Spannung erfasst und mittels geeigneter Algorithmen verarbeitet. Dabei kommt typischerweise in Mikrocontroller oder eine entsprechende Rechnereinheit zum Einsatz. Zur Stromerfassung dienen im Allgemeinen Messshunts und induktive Stromsensoren, wie Kompensationssensoren, Fluxgate- oder Hallelemente.

Aus der EP-A 1 435 524 ist eine Batteriesensoreinheit mit einer direkt an einen Pol einer Kraftfahrzeugbatterie anschließbaren Befestigungsvorrichtung bekannt, wobei die Befestigungsvorrichtung und ein Batteriesensor zu einer integrierten Baueinheit zusammengefasst sind. Die Batteriesensorvorrichtung ist in Form und Größe an übliche Batteriepolwannen angepasst. Darüber hinaus besteht der Batteriesensor aus einem planaren Messshunt und einer Elektronikeinheit, wobei der Messshunt als Widerstandselement mit zwei als mechanische Träger ausgebildeten Widerstandsanschlüssen ausgestaltet ist.

DE 100 31243 zeigt eine Batteriesensoreinheit, bei der zwischen dem Klemmkontakt und dem Batteriepol eine Widerstandsmateriallage als Messwiderstand dient.

### Offenbarung der Erfindung

Gegenüber dem Stand der Technik weist das erfindungsgemäße Verfahren, das durch Anspruch 1 definiert ist, zur Herstellung einer Batteriesensoreinheit, insbesondere einer Batteriesensoreinheit für eine Kraftfahrzeug-Batterie, mit einer Kabelaufnahme für ein Kabelende eines Kabels den Vorteil eines gegenüber herkömmlichen Batteriesensoreinheiten deutlich vereinfachten Produktionsprozesses in Verbindung mit einer signifikanten Kostenersparnis auf. Dazu wird auf das Kabelende eine aus einem Widerstandsmaterial bestehende Hülse aufgeschoben, wobei zwischen dem Kabelende und einem inneren Umfang der Hülse zumindest ein erster Messabgriff eingebracht ist. Das mit der Hülse und dem Messabgriff versehene Kabelende wird schließlich in die Kabelaufnahme eingeführt und mit dieser zu einer Messvorrichtung dauerhaft verbunden. Auf diese Weise entsteht eine Batteriesensoreinheit gemäß Anspruch 15 mit einer Befestigungsvorrichtung zur Befestigung der Batteriesensoreinheit an einen Kontakt bzw. Pol einer Batterie, insbesondere einer Kraftfahrzeug-Batterie, und mit einer Messvorrichtung zur Erfassung des Zustands der Batterie. Die Messvorrichtung umfasst in vorteilhafter Weise ein Kabelende eines Kabels, eine das Kabelende umschließende, aus einem Widerstandsmaterial bestehende Hülse, zumindest einen ersten zwischen einem inneren Umfang der Hülse und dem Kabelende eingebrachten Messabgriff sowie eine die Hülse in einer dauerhaften Verdindung aufnehmende Kabelaufnahme.

Weitere vorteilhafte Ansgestaltungen der Erfindung ergeben sich durch die in den abhängigen Ansprüchen angegebenen Merkmale sowie aus der Zeichnung und der nachfolgenden Beschreibung.

So kann in einer ersten Ausgestaltung des Herstellungsverfahren der Batteriesensoreinheit der zumindest eine erste Messabgriff zwischen das Kabelende und die Hülse eingebracht werden, nachdem die Hülse auf das Kabelende aufgeschoben wurde. Alternativ ist es möglich, dass der zumindest eine erste Messabgriff auf das Kabelende aufgesetzt wird und anschließlend die Hülse auf das Kabelende und den Messabgriff aufgeschoben wird. Schließlich ergibt sich eine weitere Möglichkeit des Herstellungsverfahrens, wenn der zumindest eine erste Messabgriff zunächst in die Hülse eingesteckt wird und anschließend die Hülse und der Messabgriff auf das Kabelende aufgeschoben werden. Zu diesem Zweck ist es von Vorteil, wenn der zumindest eine erste Messabgriff zwei in etwa rechtwinklig zueinander ausgerichtete Schenkel aufweist, wobei der zumindst eine erste Messabgriff mit dem ersten Schenkel an der Messvorrichtung befestigt wird und der zweite Schenkel zum Abgreifen eines ersten elektrischen Potentials dient.

Um einen möglichst guten Kontakt zwischen dem Kabelende, dem Messabgriff und der Hülse zu gewährleisten, ist es vorteilhaft, wenn das Kabelende vor dem Aufschieben der Hülse in etwa über die Länge der Hülse abisoliert wird.

Eine besonders kostengünstige und vor allen Dingen in der Serie reproduzierbare, dauerhafte Verbindung zwischen der Aufnahme, der Hülse, dem Messabgriff und dem Kabelende ergibt sich, wenn diese eine Verpressung, Quetschung oder Krimpung ist. Um eine Serienkonstanz der Messvorrichtung zu gewährleisten und somit stets nachvollziehbare Messergebnisse über den Zustand der Batterie zu erhalten, wird die Verpressung, Quetschung oder Krimpung mit einem definierten Druck ausgeführt.

Da in der Regel ein Spannungsabfall unmittelbar über der aus dem Widerstandsmaterial bestehenden Hülse gemessen werden soll, die demzufolge als ein Messshunt arbeitet, ist es von Vorteil, wenn ein weiterer Messabgriff von außen auf die Kabelaufnahme aufgebracht wird. Dieser weitere Messabgriff kann beispielsweise mit der Kabelaufnahme verlötet, verschweißt, verpresst, verschraubt oder verklebt werden. Als Widerstandsmaterial der Hülse bietet sich vor allen Dingen Manganan an. Wie bereits der zumindest eine erste Messabgriff, so ist auch der weitere Messabgriff bevorzugt mit zwei in etwa rechtwinklig zueinander ausgerichteten Schenkeln ausgeführt, wobei der weitere Messabgriff mit dem ersten Schenkel an der Messvorrichtung befestigt wird und der zweite Schenkel zum Abgreifen eines zweiten elektrischen Potentials dient. Auf diese Weise kann mittels der beiden Messabgriffe der Spannungsabfall über der Hülse gemessen werden.

Da die meisten Kabel einen runden Querschnitt aufweisen, bietet es sich an, dass die Kabelaufnahme und die Hülse hohlzylinderförmig ausgestaltet sind und das Kabelende, die Hülse sowie die Kabelaufnahme eine koaxiale Anordnung aufweisen.

### Zeichnung

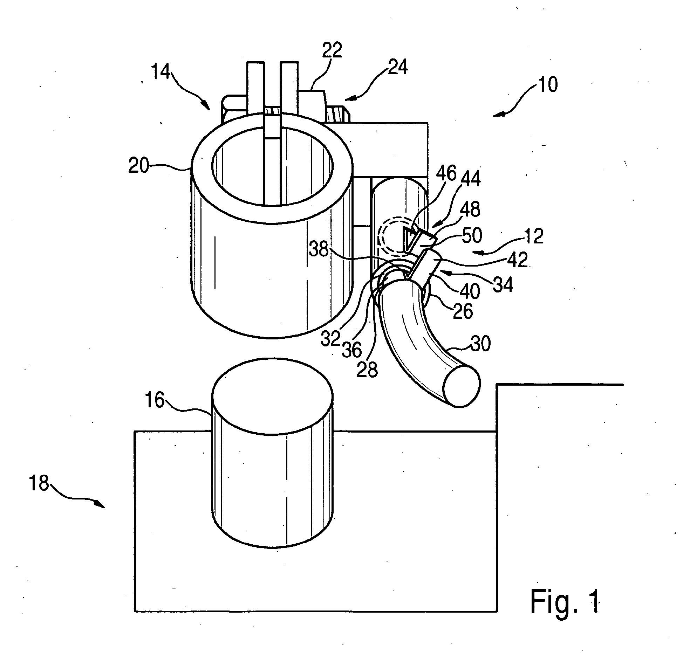

Die Erfindung wird im Folgenden anhand der Figuren 1 bis 3 beispielhaft erläutert, wobei gleiche Bezugszeichen in den Figuren auf gleiche Bestandteile mit einer gleichen Funktionsweise hindeuten. Die Figuren der Zeichnung, deren Beschreibung sowie die Ansprüche enthalten zahlreiche Merkmale in Kombination. Ein Fachmann wird diese Merkmale auch einzeln betrachten und zu weiteren sinnvollen Kombinationen zusammenfassen. Insbesondere wird ein Fachmann auch die Merkmale aus unterschiedlichen Ausführungsbeispielen zu weiteren sinnvollen Kombinationen zusammenfassen.

### Es zeigen

Fig. 1: ein Ausführungsbeispiel für eine erfindungsgemäße Batteriesensoreinheit mit einer Messvorrichtung zur Erfassung des Zustands einer Kraftfahrzeug-Batterie,
Fig. 2: eine Seitenansicht der zusammengesetzten Messvorrichtung der erfindungsgemäßen Batteriesensoreinheit in einem Querschnitt und
Fig. 3: eine Explosionszeichnung der Messvorrichtung der erfindungsgemäßen Batteriesensoreinheit.

Figur 1 zeigt ein Ausführungsbeispiel der erfindungsgemäßen Batteriesensoreinheit 10 mit einer Messvorrichtung 12 und einer Befestigungsvorrichtung 14. Die Befestigungsvorrichtung 14 dient zur Bildung einer lösbaren, elektrischen Verbindung zwischen der Batteriesensoreinheit 10 und einem Kontakt 16 bzw. Pol einer Kraftfahrzeug-Batterie 18. Dazu wird die Befestigungsvorrichtung 14 mittels einer auf einen Klemmkörper 20 wirkenden Klemmschraube 22 in Gestalt einer Polklemme 24 mit dem Kontakt 16 bzw. Pol der Batterie 18 verbunden, indem die Befestigungsvorrichtung 14 über den Kontakt 16 gestülpt und die Klemmschraube 22 mit einem geeigneten Werkzeug angezogen wird.

Die Messvorrichtung 12 der Batteriesensoreinheit 10 weist eine hohlzylinderförmige Kabelaufnahme 26 für ein Kabelende 28 eines Kabels 30, insbesondere eines Energieversorgungskabels, zur dauerhaften Verbindung mit einem Bordnetz des Kraftfahrzeugs auf und dient zur Erfassung des Zustandes der Kraftfahrzeug-Batterie 18. Dazu umschließt eine aus einem Widerstandsmaterial bestehende, ebenfalls hohlzylinderförmige Hülse 32 das vorzugsweise abisolierte Kabelende 28, so dass das Kabelende 28, die Hülse 32 und die Kabelaufnahme 26 gemäß den gestrichelten Linien eine koaxiale Anordnung bilden. Unter dem Begriff hohlzylinderförmig wird verstanden, dass zumindest ein axiales Ende des Hohlzylinders offen ist. Ohne Einschränkung der

Erfindung können die Kabelaufnahme 26-und die Hülse 32 aber auch andere Formen, beispielsweise eine Quaderform oder dergleichen, besitzen. Dies ist dann von Vorteil, wenn es sich bei dem Kabel 30 um ein Flachbandkabel oder ein Kabel mit einem anderen Querschnitt handelt.

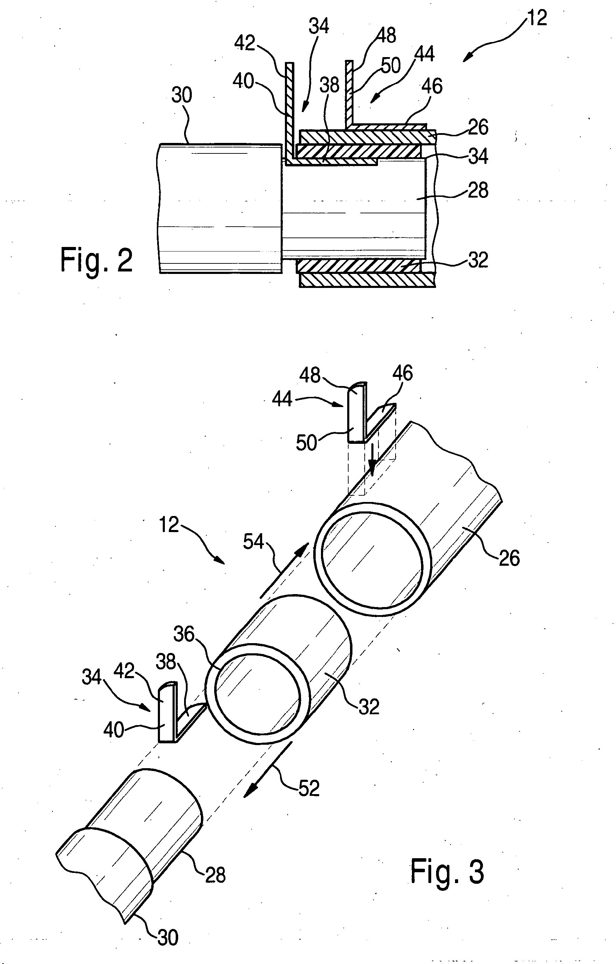

Um den Zustand der Batterie 18 erfassen zu können, ist zumindest ein erster Messabgriff 34 zwischen einem inneren Umfang 36 der Hülse 32 und dem Kabelende 28 eingebracht (vgl. auch Figur 2). Auf das Verfahren zum Einbringen des zumindest einen ersten Messabgriffs 34 soll später im Zusammenhang mit Figur 3 näher eingegangen werden. Der zumindest eine erste Messabgriff 34 verfügt über zwei in etwa rechtwinklig zueinander ausgerichtete Schenkel 38 und 40, wobei der erste Schenkel 38 zur Kontaktierung und Befestigung des ersten Messabgriffs 34 an der Messvorrichtung 12 dient, und der zweite Schenkel 40 einen Anschlusskontakt 42 zum Abgreifen eines ersten elektrischen Potentials bildet. Darüber hinaus ist ein weiterer Messabgriff 44 von außen auf die Kabelaufnahme 26 aufgebracht, beispielsweise durch Verlöten, Verschweißen, Verpressen, Verschrauben oder Verkleben. Wie der zumindest eine erste Messabgriff 34 so weist auch der weitere Messabgriff 44 zwei in etwa rechtwinklig zueinander ausgerichtete Schenkel 46, 48 auf, wobei der erste Schenkel 46 zur Befestigung und Kontaktierung des weiteren Messabgriffs 44 an der Messvorrichtung 12 dient, während an einem Anschlusskontakt 48 des zweiten Schenkels 50 ein zweites elektrisches Potential abgreifbar ist. Die Differenz zwischen dem zweiten elektrischen Potential und dem ersten elektrischen Potential bildet dann einen aus dem fließenden Batteriestrom resultierenden Spannungsabfall über der als Messshunt arbeitenden Hülse 32, mittels dem der Zustand der Batterie 18 durch eine nicht gezeigte Rechnereinheit, beispielsweise einen Microcontroller oder dergleichen, erfassbar ist.

Als Material für die Kabelaufnahme 12, den zumindest einen ersten Messabgriff 34, den weiteren Messabgriff 44 und das Kabel 30 (ausgenommen dessen Isolierung) bietet sich Kupfer oder ein sonstiger guter Leiter an. Für die Hülse 32 kann in vorteilhafter Weise Manganan als Widerstandsmaterial verwendet werden.

Anhand von Figur 3 soll nun das Verfahren zur Herstellung der Batteriesensoreinheit 10 beschrieben werden. Dazu wird zunächt auf das Kabelende 28, das vorzugsweise in etwa über die Länge der Hülse 32 abisoliert ist, die aus dem Widerstandsmaterial bestehende Hülse 32 in Richtung des Pfeils 52 aufgeschoben, wobei zwischen dem Kabelende 28 und dem inneren Umfang 36 der Hülse 32 der zumindest eine erste Messabgriff 34 eingebracht ist. Anschließend wird dann das mit der Hülse 32 und dem Messabgriff 34 versehene Kabelende 28 in Richtung des Pfeils 54 in die Kabelaufnahme 26 eingeführt und mit dieser zu der Messvorrichtung 12 dauerhaft verbunden. Die dauerhafte Verbindung geschieht dabei durch eine Verpressung, Quetschung oder Krimpung, die von außen mit einem definierten Druck auf die Kabelaufnahme 26 ausgeübt wird. Dieser definierte Druck ist wichtig, um einen in der Serienfertigung konstanten Widerstandswert der Messvorrichtung 12 zu gewährleisten. Weiterhin kann auch vorgesehen sein, dass die Hülse 32 einen axialen Schlitz aufweist, der das Verpressen, Quetschen oder Krimpen erleichtert und ein versehentliches Herausziehen des Kabelendes 28 erschwert. Der Schlitz kann sich dabei über die gesamte Länge der Hülse 32 erstrecken oder auch nur einen Teil, beispielsweise die Hälfte oder Dreiviertel der Länge, abdecken, wobei im letzteren Fall das geschlitzte Ende der Hülse 32 vorzugsweise in Richtung des Kabels 30 zeigt.

Die Hülse 32 und die Kabelaufnahme 26 sind im gezeigten Ausführungsbeispiel hohlzylinderförmig ausgestaltet, so dass das Kabelende 28, die Hülse 32 und die Kabelaufnahme 26 eine koaxiale Anordnung ergeben. Wie bereits weiter oben erwähnt, sind in Abhängigkeit von der Form des Kabels 30 aber auch andere Ausgestaltungen denkbar.

Für das Einbringen des zumindest einen ersten Messabgriffs 34 zwischen das Kabelende 28 und die Hülse 32 existieren verschiedene Möglichkeiten. So kann der zumindest eine erste Messabgriff 34 beispielsweise erst nach Aufschieben der Hülse 32 auf das Kabelende 28 mittels eines geeigneten Werkzeugs eingeschoben werden. Dazu wird der Messabgriff 34 an seinem zweiten Schenkel 40 gegriffen und mit seinem in etwa rechtwinklig zum zweiten Schenkel ausgerichteten ersten Schenkel 38 zwischen das Kabelende 28 und den inneren Umfang 36 der Hülse 32 eingesteckt. Aufgrund der anchließenden Verpressung, Quetschung oder Krimpung der Kabelaufnahme 26 ist keine weitere Fixierung erforderlich. Alternativ ist es möglich, dass der zumindest eine erste Messabgriff 34 mit seinem ersten Schenkel 38 auf das Kabelende 28 aufgesetzt wird und anschließend ein Aufschieben der Hülse 32 auf das Kabelende 28 und den Messabgriff 34 bzw. dessen ersten Schenkel 38 erfolgt. Schließlich kann auch angedacht sein, den Messabgriff 34 mit seinem ersten Schenkel 38 zunächst in die Hülse 32 einzustecken, um dann die Hülse 32 zusammen mit dem Messabgriff 34 auf das Kabelende 28 aufzuschieben.

Bei der zweiten Methode ist ein vollständiges Abisolieren des Kabelendes 28 über die ungefähre Länge der Hülse 32 nicht unbedingt erforderlich. So kann der erste Schenkel 38 beispielsweise Kontaktspitzen oder -nadeln aufweisen, die beim Aufsetzen auf das Kabelende 28 durch die Isolierung hindurch einen elektrischen Kontakt mit der Kupferseele des Kabels 30, insbesondere nach dem Verpressen, Quetschen oder Krimpen der Kabelaufnahme 26, gewährleisten.

Nachdem die Messvorrichtung 12 aus einer dauerhaften Verbindung zwischen dem Kabel 30, dem zumindest einen ersten Messabgriff 34, der Hülse 32 und der Kabelaufnahme 26 besteht, wird der weitere Messabgriff 44 von außen mit seinem ersten Schenkel 46 auf die Kabelaufnahme 26 aufgebracht. Dies geschieht beispielsweise durch Verlöten, Verschweißen, Verpressen, Verschrauben, Verkleben oder dergleichen. Der in etwa rechtwinklig zum ersten Schenkel 46 ausgerichtete zweite Schenkel 50 dient dann, wie beim zumindest einen ersten Messabgriff 34, zum Abgreifen eines zweiten elektrischen Potentials an dessen Anschlusskontakt 48.

Es sei abschließend noch darauf hingewiesen, dass das gezeigte Ausführungsbeispiel weder auf die Figuren 1 bis 3 noch auf die gezeigten Formen der Messabgriffe 34 und 44 sowie des Kabel 30, der Hülse 32, der Kabelaufnahme 26, der Messvorrichtung 12 und der gesamten Batteriesensoreinheit 10 beschränkt ist. Insbesondere die Messabgriffe 34 und 44 lassen sich vielfältigst gestalten. Weiterhin kann für die Messvorrichtung 12 auch ein anderes leitfähiges Material als Kupfer bzw. Widerstandsmaterial als Manganan verwendet werden. Der Fachmann wird hier aus einer Vielzahl in Frage kommender Materialen auswählen.

## Patentansprüche

1. Verfahren zur Herstellung einer Batteriesensoreinheit (10), insbesondere einer Batteriesensoreinheit für eine Kraftfahrzeug-Batterie, mit einer Kabelaufnahme (26) für ein Kabelende (28) eines Kabels (30), wobei auf das Kabelende (28) eine aus einem Widerstandsmaterial bestehende Hülse (32) aufgeschoben wird, wobei zwischen dem Kabelende (28) und einem inneren Umfang (36) der Hülse (32) zumindest ein erster Messabgriff (34) eingebracht ist, und dass das mit der Hülse (32) und dem Messabgriff (34) versehene Kabelende (28) in die Kabelaufnahme (26) eingeführt und mit dieser zu einer Messvorrichtung (12) dauerhaft verbunden wird.

2. Verfahren nach Anspruch 1, **dadurch gekennzeichnet, dass** der zumindest eine erste Messabgriff (34) zwischen das Kabelende (28) und die Hülse (32) eingeschoben wird, nachdem die Hülse (32) auf das Kabelende (28) aufgeschoben wurde.

3. Verfahren nach Anspruch 1, **dadurch gekennzeichnet, dass** der zumindest eine erste Messabgriff (34) auf das Kabelende (28) aufgesetzt wird und anschließlend die Hülse (32) auf das Kabelende (28) und den Messabgriff (34) aufgeschoben wird.

4. Verfahren nach Anspruch 1, **dadurch gekennzeichnet, dass** der zumindest eine erste Messabgriff (34) zunächst in die Hülse (32) eingesteckt wird und anschließend die Hülse (32) und der Messabgriff (34) auf das Kabelende (28) aufgeschoben werden.

5. Verfahren nach einem der vorhergehenden Ansprüche, **dadurch gekennzeichnet, dass** der zumindest eine erste Messabgriff (34) zwei in etwa rechtwinklig zueinander ausgerichtete Schenkel (38, 40) aufweist, wobei der zumindest eine erste Messabgriff (34) mit dem ersten Schenkel (38) an der Messvorrichtung (12) befestigt wird und der zweite Schenkel (40) zum Abgreifen eines ersten elektrisches Potentials dient.

6. Verfahren nach einem der vorherigen Ansprüche, **dadurch gekennzeichnet, dass** das Kabelende (28) vor dem Aufschieben der Hülse (32) in etwa über die Länge der Hülse (32) abisoliert wird.

7. Verfahren nach Anspruch 1, **dadurch gekennzeichnet, dass** die dauerhafte Verbindung eine Verpressung, Quetschung oder Krimpung ist.

8. Verfahren nach Anspruch 7, **dadurch gekennzeichnet, dass** die Verpressung, Quetschung oder Krimpung mit einem definierten Druck ausgeführt wird.

9. Verfahren nach einem der vorhergehenden Ansprüche, **dadurch gekennzeichnet, dass** ein weiterer Messabgriff (44) von außen auf die Kabelaufnahme (26) aufgebracht wird.

10. Verfahren nach Anspruch 9, **dadurch gekennzeichnet, dass** der weitere Messabgriff (44) mit der Kabelaufnahme (26) verlötet, verschweißt, verpresst, verschraubt oder verklebt wird.

11. Verfahren nach Anspruch 10, **dadurch gekennzeichnet, dass** der weitere Messabgriff (44) zwei in etwa rechtwinklig zueinander ausgerichtete Schenkel (46, 50) aufweist, wobei der weitere Messabgriff (44) mit dem ersten Schenkel (46) an der Messvorrichtung (12) befestigt wird und der zweite Schenkel (50) zum Abgreifen eines zweiten elektrischen Potentials dient.

12. Verfahren nach Anspruch 1, **dadurch gekennzeichnet, dass** das Widerstandsmaterial der Hülse (32) Manganan ist.

13. Verfahren nach einem der vorhergehenden Ansprüche, **dadurch gekennzeichnet, dass** die Kabelaufnahme (26) und die Hülse (32) hohlzylinderförmig ausgestaltet sind.

14. Verfahren nach einem der vorhergehenden Ansprüche, **dadurch gekennzeichnet, dass** das Kabelende (28), die Hülse (32) und die Kabelaufnahme (26) koaxial angeordnet sind.

15. Batteriesensoreinheit (10) mit einer Befestigungsvorrichtung (14) zur Befestigung der Batteriesensoreinheit (10) an einen Kontakt (16) einer Batterie (18), insbesondere einer Kraftfahrzeug-Batterie, und mit einer Messvorrichtung (12) zur Erfassung des Zustands der Batterie wobei die Messvorrichtung (12) ein Kabelende (28) eines Kabels (30), eine das Kabelende (28) umschließende, aus einem Widerstandsmaterial bestehende Hülse (32), zumindest einen ersten zwischen einen inneren Umfang (36) der Hülse (32) und dem Kabelende (28) eingebrachten Messabgriff (34) sowie eine die Hülse (32) in einer dauerhaften Verdindung aufnehmende Kabelaufnahme (26) umfasst.

16. Batteriesensoreinheit (10) nach Anspruch 15**, dadurch gekennzeichnet, dass** die Kabelaufnahme (26) und die Hülse (32) hohlzylinderförmig ausgestaltet sind.

17. Batteriesensoreinheit (10) nach Anspruch 15 oder 16, **dadurch gekennzeichnet, dass** das Kabelende (28), die Hülse (32) und die Kabelaufnahme (26) koaxial angeordnet sind.

18. Batteriesensoreinheit (10) nach einem der vorhergehenden Ansprüche 15 bis 17, **dadurch gekennzeichnet, dass** das Widerstandsmaterial der Hülse (32) Manganan ist.

19. Batteriesensoreinheit (10) nach einem der vorhergehenden Ansprüche 15 bis 18, **dadurch gekennzeichnet, dass** die Messvorrichtung (12) einen weiteren, von außen auf die Kabelaufnahme (26) aufgebrachten Messabgriff (44) umfasst.

20. Batteriesensoreinheit (10) nach Anspruch 19, **dadurch gekennzeichnet, dass** der zumindest eine erste (34) und der weitere Messabgriff (44) jeweils zwei in etwa rechtwinklig zueinander ausgerichteten Schenkel (38, 40; 46, 50) aufweisen, wobei die ersten Schenkel (38, 46) zur Kontaktierung und Befestigung an der Messvorrichtung (12) dienen und die zweiten Schenkel (40, 50) jeweils einen Anschlusskontakt (42, 48) zum Abgreifen eines Spannungsabfalls über der Hülse (32) bilden.

## Claims

1. Method for production of a battery sensor unit (10), in particular of a battery sensor unit for a motor vehicle battery, having a cable holder (26) for a cable end (28) of a cable (30), wherein a sleeve (32) which is composed of a resistance material is pushed onto the cable end (28), wherein at least one first measurement tap (34) is fitted between the cable end (28) and an internal circumference (36) of the sleeve (32), and wherein the cable end (28) which is provided with the sleeve (32) and the measurement tap (34) is inserted into the cable holder (26) and is permanently connected to it to form a measurement apparatus (12).

2. Method according to Claim 1, **characterized in that** the at least one first measurement tap (34) is pushed in between the cable end (28) and the sleeve (32) after the sleeve (32) has been pushed onto the cable end (28).

3. Method according to Claim 1, **characterized in that** the at least one first measurement tap (34) is fitted to the cable end (28), and the sleeve (32) is then pushed onto the cable end (28) and the measurement tap (34).

4. Method according to Claim 1**, characterized in that** the at least one first measurement tap (34) is first of all inserted into the sleeve (32), and the sleeve (32) and the measurement tap (34) are then pushed onto the cable end (28).

5. Method according to one of the preceding claims, **characterized in that** the at least one first measurement tap (34) has two limbs (38, 40), which are aligned approximately at right angles to one another, wherein the at least one first measurement tap (34) is attached by the first limb (38) to the measurement apparatus (12), and the second limb (40) is used to tap off a first electrical potential.

6. Method according to one of the preceding claims, **characterized in that,** before the sleeve (32) is pushed on, the cable end (28) is stripped approximately over the same length as the sleeve (32).

7. Method according to Claim 1, **characterized in that** the permanent connection is a compression, pinching or crimping.

8. Method according to Claim 7, **characterized in that** the compression, pinching or crimping is carried out with a defined pressure.

9. Method according to one of the preceding claims, **characterized in that** a further measurement tap (44) is fitted on the outside to the cable holder (26).

10. Method according to Claim 9**, characterized in that** the further measurement tap (44) is soldered, welded, pressed, screwed or adhesively bonded to the cable holder (26).

11. Method according to Claim 10, **characterized in that** the further measurement tap (44) has two limbs (46, 50), which are aligned approximately at right angles to one another, wherein the further measurement tap (44) is attached by the first limb (46) to the measurement apparatus (12), and the second limb (50) is used to tap off a second electrical potential.

12. Method according to Claim 1, **characterized in that** the resistance material of the sleeve (32) is manganan.

13. Method according to one of the preceding claims, **characterized in that** the cable holder (26) and the sleeve (32) are hollow-cylindrical.

14. Method according to one of the preceding claims, **characterized in that** the cable end (28), the sleeve (32) and the cable holder (26) are arranged coaxially.

15. Battery sensor unit (10) having an attachment apparatus (14) for attachment of the battery sensor unit (10) to a contact (16) of a battery (18), in particular of a motor vehicle battery, and having a measurement apparatus (12) for detection of the state of the battery, wherein the measurement apparatus (12) comprises a cable end (28) of a cable (30), a sleeve (32) which surrounds the cable end (28) and is composed of a resistance material, at least one first measurement tap (34), which is fitted between an internal circumference (36) and the sleeve (32) and the cable end (28), as well as a cable holder (26) which holds the sleeve (32) in a permanent connection.

16. Battery sensor unit (10) according to Claim 15, **characterized in that** the cable holder (26) and the sleeve (32) are hollow-cylindrical.

17. Battery sensor unit (10) according to Claim 15 or 16, **characterized in that** the cable end (28), the sleeve (32) and the cable holder (26) are arranged coaxially.

18. Battery sensor unit (10) as claimed in one of the preceding Claims 15 to 17, **characterized in that** the resistance material of the sleeve (32) is manganan.

19. Battery sensor unit (10) according to one of the preceding Claims 15 to 18, **characterized in that** the measurement apparatus (12) has a further measurement tap (44), which is fitted on the outside to the cable holder (26).

20. Battery sensor unit (10) according to Claim 19, **characterized in that** the at least one first measurement tap (34) and the further measurement tap (44) each have two limbs (38, 40; 46, 50) which are aligned approximately at right angles to one another, wherein the first limbs (38, 46) are used to make contact with and for attachment to the measurement apparatus (12), and the second limbs (40, 50) respectively form a connecting contact (42, 48) for tapping off a voltage drop across the sleeve (32).

## Revendications

1. Procédé de fabrication d'une unité de détecteur de batterie (10), en particulier d'une unité de détecteur de batterie pour une batterie de véhicule automobile, avec un logement de câble (26) pour une extrémité de câble (28) d'un câble (30), dans lequel une douille (32) constituée d'une matière de résistance est glissée sur l'extrémité de câble (28), dans lequel au moins une première prise de mesure (34) est insérée entre l'extrémité de câble (28) et une périphérie intérieure (36) de la douille (32), et en ce que l'extrémité de câble (28) pourvue de la douille (32) et de la prise de mesure (34) est introduite dans le logement de câble (26) et est durablement raccordée avec celui-ci à un dispositif de mesure (12).

2. Procédé selon la revendication 1, **caractérisé en ce que** l'au moins une première prise de mesure (34) est insérée entre l'extrémité de câble (28) et la douille (32), après que la douille (32) ait été glissée sur l'extrémité de câble (28).

3. Procédé selon la revendication 1, **caractérisé en ce que** l'au moins une première prise de mesure (34) est appliquée sur l'extrémité de câble (28) et la douille (32) est ensuite glissée sur l'extrémité de câble (28) et la prise de mesure (34).

4. Procédé selon la revendication 1, **caractérisé en ce que** l'au moins une première prise de mesure (34) est engagée dans la douille (32) et la douille (32) et la prise de mesure (34) sont ensuite glissées sur l'extrémité de câble (28).

5. Procédé selon l'une quelconque des revendications précédentes, **caractérisé en ce que** l'au moins une première prise de mesure (34) présente deux branches (38, 40) orientées environ perpendiculairement l'une à l'autre, dans lequel l'au moins une première prise de mesure (34) est fixée par la première branche (38) au dispositif de mesure (12) et la deuxième branche (40) sert à prendre un premier potentiel électrique.

6. Procédé selon l'une quelconque des revendications précédentes, **caractérisé en ce que** l'on dénude l'extrémité de câble (28) sur environ la longueur de la douille (32) avant de glisser la douille (32).

7. Procédé selon la revendication 1, **caractérisé en ce que** la liaison durable est un pressage, un serrage ou un frettage.

8. Procédé selon la revendication 7, **caractérisé en ce que** le pressage, le serrage ou le frettage est exécuté avec une pression définie.

9. Procédé selon l'une quelconque des revendications précédentes, **caractérisé en ce qu'**une autre prise de mesure (44) est placée de l'extérieur sur le logement de câble (26).

10. Procédé selon la revendication 9, **caractérisé en ce que** l'on brase, soude, presse, visse ou colle l'autre prise de mesure (44) au logement de câble (26).

11. Procédé selon la revendication 10, **caractérisé en ce que** l'autre prise de mesure (44) présente deux branches (46, 50) orientées environ perpendiculairement l'une à l'autre, dans lequel l'autre prise de mesure (44) est fixée par la première branche (46) au dispositif de mesure (12) et la deuxième branche (50) sert à prendre un deuxième potentiel électrique.

12. Procédé selon la revendication 1, **caractérisé en ce que** la matière de résistance de la douille (32) est le manganan.

13. Procédé selon l'une quelconque des revendications précédentes, **caractérisé en ce que** le logement de câble (26) et la douille (32) se présentent sous une forme cylindrique creuse.

14. Procédé selon l'une quelconque des revendications précédentes, **caractérisé en ce que** l'extrémité de câble (28), la douille (32) et le logement de câble (26) sont disposés de manière coaxiale.

15. Unité de détecteur de batterie (10) avec un dispositif de fixation (14) pour la fixation de l'unité de détecteur de batterie (10) sur un contact (16) d'une batterie (18), en particulier d'une batterie de véhicule automobile, et avec un dispositif de mesure (12) pour détecter l'état de la batterie, dans laquelle le dispositif de mesure (12) comprend une extrémité de câble (28) d'un câble (30), une douille (32) composée d'une matière de résistance et entourant l'extrémité de câble (28), au moins une première prise de mesure (34) insérée entre une périphérie intérieure (36) de la douille (32) et l'extrémité de câble (28), ainsi qu'un logement de câble (26) contenant la douille (32) dans une liaison durable.

16. Unité de détecteur de batterie (10) selon la revendication 15, **caractérisée en ce que** le logement de câble (26) et la douille (32) se présentent sous une forme cylindrique creuse.

17. Unité de détecteur de batterie (10) selon la revendication 15 ou 16, **caractérisée en ce que** l'extrémité de câble (28), la douille (32) et le logement de câble (26) sont disposés de manière coaxiale.

18. Unité de détecteur de batterie (10) selon l'une quelconque des revendications précédentes 15 à 17, **caractérisée en ce que** la matière de résistance de la douille (32) est le manganan.

19. Unité de détecteur de batterie (10) selon l'une quelconque des revendications précédentes 15 à 18, **caractérisée en ce que** le dispositif de mesure (12) comprend une autre prise de mesure (44), placée de l'extérieur sur le logement de câble (26).

20. Unité de détecteur de batterie (10) selon la revendication 19, **caractérisée en ce que** l'au moins une première prise de mesure (34) et l'autre prise de mesure (44) présentent chacune deux branches (38, 40; 46, 50) orientées environ perpendiculairement l'une à l'autre, dans laquelle les premières branches (38, 46) servent pour le contact et la fixation au dispositif de mesure (12) et les deuxièmes branches (40, 50) forment chaque fois un contact de raccordement (42, 48) pour mesurer une chute de tension à travers la douille (32).
